# EUROPEAN PATENT APPLICATION

(11) **EP 4 766 038 A1**
(43) Date of publication of application: **24.06.2026**
(21) Application number: 25220302.1
(22) Date of filing: 03.12.2025
(51) Int. Cl.: H05K 1/11, H05K 3/341

(54) **MULTILAYER BOARD**

(30) Priority: 20.12.2024 JP 2024224874
(71) Applicant: Alps Alpine Co., Ltd., Ota-ku, Tokyo 145-8501 (JP)
(72) Inventor: Yasumoto, Takashi, Iwaki-city Fukushima (JP)
(74) Representative: Schmitt-Nilson Schraud Waibel Wohlfrom Patentanwälte Partnerschaft mbB

(57) **Abstract**

A multilayer board includes a first conductor layer, a second conductor layer, and an insulating layer. The first conductor layer and the second conductor layer are stacked via the insulating layer. The first conductor layer includes a plurality of lands to which an electrode of an electronic component for surface mounting is to be soldered. The second conductor layer includes an interconnect pattern electrically connected to the lands via a conductive through-hole formed in the insulating layer. The plurality of lands have a same planar shape.

## Description

The present disclosure relates to a multilayer board for surface-mounting of an electronic component, and specifically to a multilayer board for surface-mounting of a micro light emitting diode (LED).

A micro light emitting diode (hereinafter referred to as a microLED) capable of directly displaying an image from a light emitting diode was developed, and mounting of the microLED on a film-type board has been studied. For example, JP 2007-27510 A discloses a multilayer board to which an electronic component is soldered based on a reference that is a mounting positioning mark formed on the surface.

Separately from the above, what is referred to as a Manhattan phenomenon is known. The Manhattan phenomenon is a phenomenon in which, when performing reflow soldering of an electronic component to a board surface, one electrode of the electronic component is soldered to a land, whereas the other electrode rises from the land and the standing electrode of the electronic component is not bonded to the land. This phenomenon is presumed to occur for the following reason. Specifically, melting of solder occurs earlier on one side of the land than on the other side of the land, and solidifying of the solder occurs earlier on the one side of the land than on the other side of the land, thereby applying a tensile force (moment) to the electronic component due to a surface tension in accordance with the solidifying of the solder (JP 2005-116918 A).

The present disclosure relates to a multilayer board according to the appended claims. Embodiments are disclosed in the dependent claims. A multilayer board according to an aspect of the present disclosure includes a first conductor layer, a second conductor layer, and an insulating layer. The first conductor layer and the second conductor layer are stacked via the insulating layer. The first conductor layer includes a plurality of lands to which an electrode of an electronic component for surface mounting is to be soldered. The second conductor layer includes an interconnect pattern electrically connected to the lands via a conductive through-hole formed in the insulating layer. The plurality of lands have a same planar shape.
FIG. 1A and FIG. 1B are diagrams for describing a self-alignment effect through a reflow process.
FIG. 2 is a diagram for describing issues to address in the reflow process.
FIG. 3A is a diagram illustrating a land structure in which mounting failures of an electronic component are likely to occur.
FIG. 3B is a diagram illustrating an example of a land structure configured to prevent the mounting failures.
FIG. 4A and FIG. 4B are diagrams illustrating an example of interconnection in which the mounting failures of the electronic component are likely to occur.
FIG. 4C is a diagram illustrating an example of interconnection configured to prevent the mounting failures.
FIG. 5A is a cross-sectional diagram for describing the mounting failures of the electronic component due to a board structure.
FIG. 5B is a cross-sectional diagram illustrating a board structure configured to prevent the mounting failures.
FIG. 6A is a top diagram illustrating a microLED of a four-terminal package.
FIG. 6B is a bottom diagram of the microLED illustrated in FIG. 6A.
FIG. 6C is a diagram illustrating electrical connection of light emitting elements of red (R), green (G), and blue (B) in a common cathode.
FIG. 7 is a schematic plan diagram of a multilayer board according to a first embodiment of the present disclosure.
FIG. 8 is a schematic cross-sectional diagram of the multilayer board according to the first embodiment of the present disclosure.
FIG. 9 is a schematic plan diagram of a multilayer board according to a second embodiment of the present disclosure.
FIG. 10 is diagram illustrating a first conductor layer of an actual multilayer board according to the second embodiment.
FIG. 11 is a diagram illustrating microLEDs that are surface-mounted on the actual multilayer board according to the second embodiment.

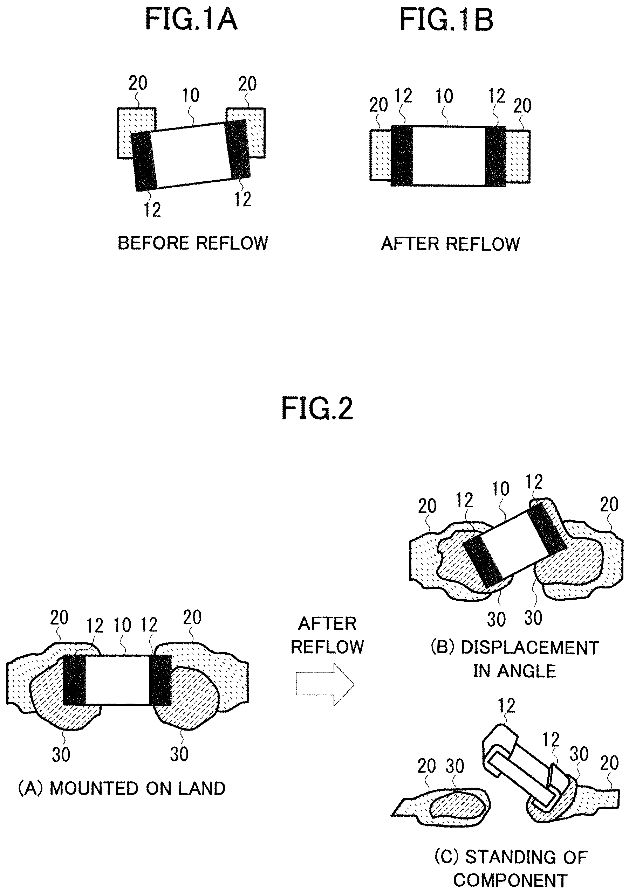

A reflow process is typically performed as a method for soldering an electronic component to a board. According to the reflow process, even if two-terminal electrodes 12 (the electrodes are formed to extend from a bottom surface to a top surface through a side surface) of an electronic component 10 are mounted in a state of being displaced from an appropriate component mounting position (land) 20 as illustrated in FIG. 1A, a self-alignment effect is exhibited in which the two-terminal electrodes 12 are guided to appropriate positions due to a surface tension of solder as illustrated in FIG. 1B.

However, when a design of a component mounting land (footprint), a design of connection of an interconnect pattern, a type and amount of solder applied, a reflow temperature profile, states of the component mounting land (wettability of solder and a modification treatment), and the like are inappropriate, even if the electronic component 10 is mounted at an appropriate position of the land 20 as illustrated in (A) of FIG. 2, mounting failures occur during or after reflow, such as positional displacement or rotation of the electronic component 10 as illustrated in (B) of FIG. 2, standing of the electronic component 10 (Manhattan phenomenon) as illustrated in (C) of FIG. 2, and the like.

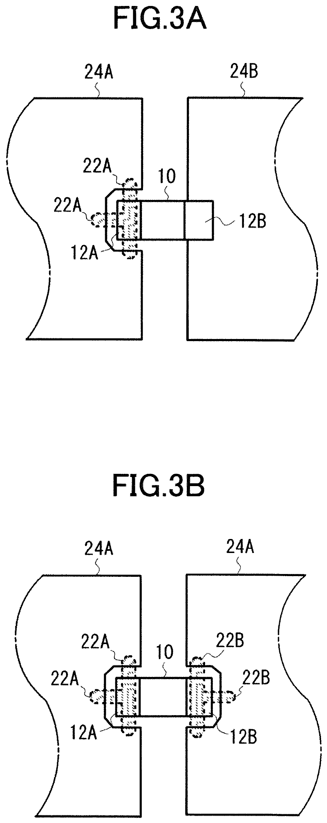

For describing an issue faced by reflow in more detail and in a simple manner, a two-terminal electronic component (e.g., a resistor or a capacitor) will be referred to. When the shape of the component mounting land or the design of the board is inappropriate, mounting failures are likely to occur. For example, as illustrated in FIG. 3A, when a land 22A to which one electrode 12A of the electronic component 10 is to be bonded is formed to be away from an interconnect pattern 24A, and a land to which the other electrode 12B is to be bonded is formed as a solid interconnect pattern 24B for improving a power supply, GND, or heat dissipation, the solder does not melt in the reflow process. As a result, as illustrated in (B) and (C) of FIG. 2, mounting failures occur, such as non-conduction in which the electrodes of the electronic component and the mounting lands of the board are not bonded, rotation of the electronic component 10, standing of the electronic component, and the like.

As a measure against this, as illustrated in FIG. 3B, it is recommendable that both the electrodes 12A and 12B of the electronic component 10 be connected to the lands 22A and 22B having a bilaterally symmetrical structure and the same pattern width.

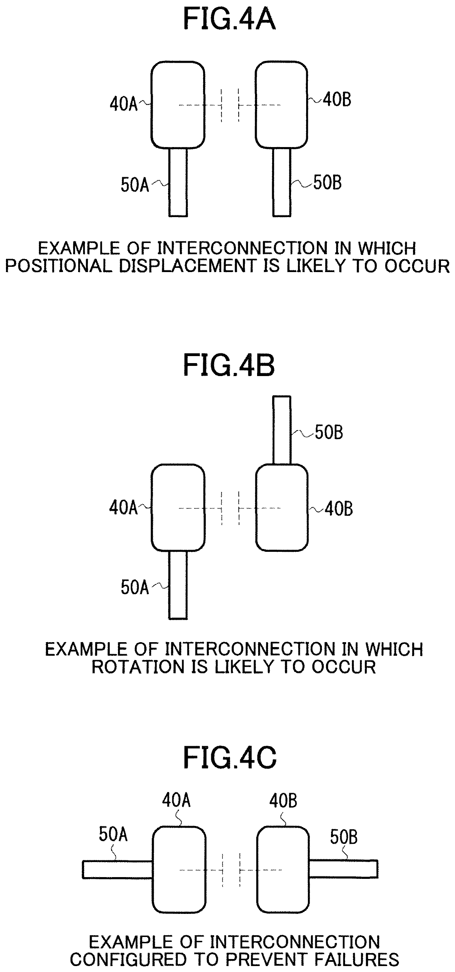

Even if lands having the same pattern width are formed, it is necessary to consider a direction in which the interconnect pattern is connected to the lands. In an inappropriate design of the interconnect pattern, the electronic components and the electrodes are small, and thus mounting failures, such as positional displacement and rotation, of the electronic components are likely to occur. In an example of interconnection illustrated in FIG. 4A, left and right electrodes of the electronic component are bonded to lands 40A and 40B having a bilaterally symmetrical structure, and left and right interconnect patterns 50A and 50B, connected to the lands 40A and 40B, extend in one direction. In such an interconnection pattern, the melting or solidifying speed of solder is different in a vertical direction of the lands, and thus positional displacement of the electronic component is likely to occur due to a resulting tensile force or the like.

In FIG. 4B, the interconnect pattern 50A connected to the land 40A extends downward, and the interconnect pattern 50B connected to the land 40B extends upward. In such an interconnection pattern, the melting or solidifying speed of solder in the left land, i.e., the land 40A, is different from that in the right land, i.e., the land 40B, and thus rotation of the electronic component is likely to occur due to a resulting rotational moment.

As a measure against this, as illustrated in FIG. 4C, the interconnect patterns 50A and 50B are disposed to be bilaterally symmetrical to extend horizontally from the lands 40A and 40B in right and left directions. In such an interconnection pattern, the tensile force or rotational moment caused by melting or solidifying of solder on the left side is canceled by that on the right side, thereby suppressing the positional displacement and rotation of the electronic component.

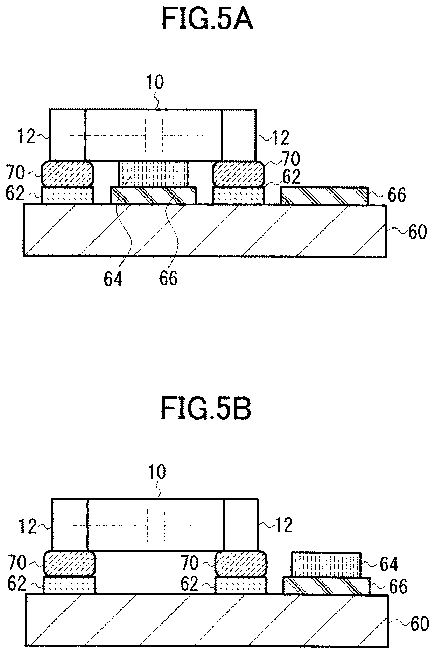

Further, for eliminating mounting failures of the electronic component, it is necessary to consider a structure (layer configuration) of a circuit board. As illustrated in FIG. 5A, lands 62 are formed on the surface of a board or base 60, and the electrodes 12 of the electronic component 10 are bonded to the lands 62 with solder 70. In the presence of, under the electronic component 10, a silkscreen layer 64 (film thickness: about 20 micrometers (µm) or more and 100 micrometers (µm) or less) indicating the shape or polarity of a component, a resist layer 66 (film thickness: 10 µm or more and several tens of micrometers or less) for rust prevention/protection/insulation of a conductor interconnect, and a passivation layer (film thickness: several nanometers (nm) or more and several micrometers or less) for insulation from a conductor layer in a photolithography process, the electronic component 10 rides on the resist layer 66 and the silkscreen layer 64, and thus the electronic component 10 tends to incline or rotate. Therefore, when the thickness of the solder is about 100 µm or more, the layer configuration is also important. As a measure against this, as illustrated in FIG. 5B, a recommendable structure does not include, under the electronic component 10, the silkscreen layer 64, the resist layer 66, and the passivation layer.

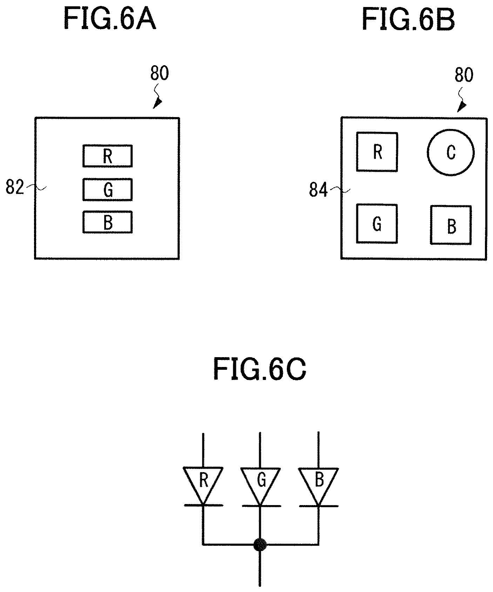

FIG. 6A is a top diagram illustrating a microLED of a four-terminal package. FIG. 6B is a bottom diagram of the microLED. FIG. 6C is a diagram illustrating electrical connection in a common cathode. A microLED 80 houses three LEDs of R, G, and B. As illustrated in FIG. 6A, the microLED 80 includes light emitting portions of R, G, and B on a top surface 82. As illustrated in FIG. 6B, the microLED 80 includes electrodes R, G, B, and C (common) of R, G, B, and C on a bottom surface 84. The electrode R is connected to the anode of the LED of R, the electrode G is connected to the anode of the LED of G, the electrode B is connected to the anode of the LED of B, and the electrode C is commonly connected to the cathodes of the LEDs of R, G, and B.

When surface-mounting the microLED on a board as an electronic component, the electrode R, the electrode G, the electrode B, and the electrode C are connected to corresponding lands through solder reflow. However, when the microLED is positionally displaced or rotated, the following failures can occur:
the microLED does not emit light at all, or there can be a situation in which only the LED of a specific color can emit light, e.g., a situation in which the LED of R emits light but the LEDs of G and B do not emit light;
light of an intended color cannot be emitted, e.g., the mounting failures of the electrode B result in emission of light of yellow rather than the intended light of white; and
the microLED mounted in an inclined state causes reduction in luminance or change in chromaticity due to an optical axis being inclined.

The present disclosure addresses issues in the art, and provides a multilayer board configured to reduce occurrence of mounting failures of electronic components.

The present disclosure relates to a multilayer board in which a plurality of interconnect layers are stacked via an insulating layer. An electronic component is mounted on the multilayer board through solder reflow. No particular limitation is imposed on the electronic component, and the electronic component is, for example, a package-type microLED including light emitting elements of R, G, and B. It should be noted that the drawings referred to in the following description include exaggerated representations for facilitating understanding of the present disclosure, and do not illustrate the shape or scale of an actual product.

### EXAMPLES

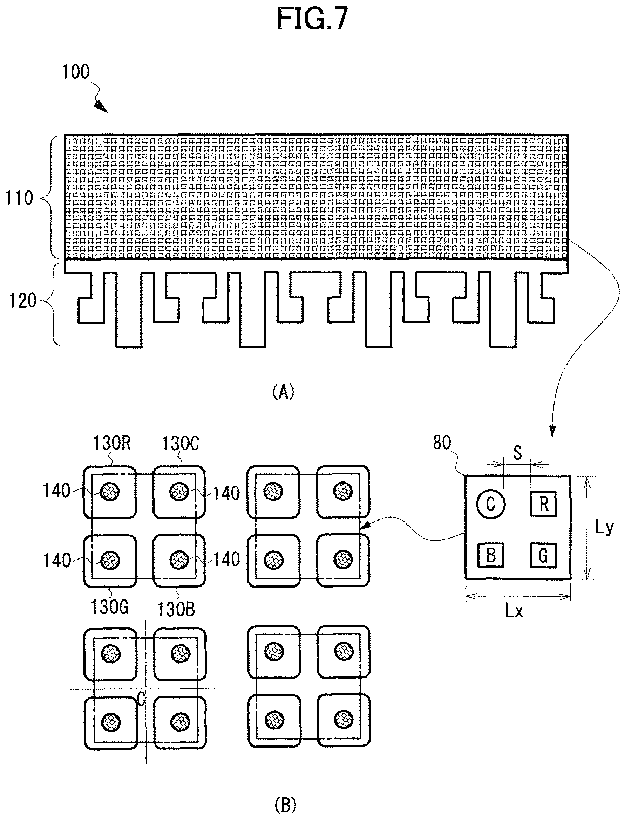

Next, a first embodiment of the present disclosure will be described. (A) of FIG. 7 is a plan diagram of the multilayer board according to the first embodiment of the present disclosure, and (B) of FIG. 7 is a plan diagram illustrating land patterns formed on the uppermost conductor layer of the multilayer board.

A multilayer board 100 of the present embodiment has a multilayer printed wiring structure in which a plurality of conductor layers are stacked via an insulating layer. No particular limitation is imposed on the insulating layer. For example, the insulating layer is formed of a material, such as a polyimide resin or PET, and provides interlayer insulation between the conductor layers in the board. The surface of the insulating layer is provided with a conductor layer that is formed, for example, of a single layer or a stacked layer of Cu, Au, Ag, Mg, Al, or ITO. The conductor layer is etched, for example, through a photolithography process to be processed into a circuit pattern or an interconnect pattern. Also, the insulating layer is provided with through-holes for electrical connection between the upper and lower conductor layers. The through-holes are filled with a conductive material, such as Cu or the like.

The multilayer board 100 of the present embodiment is a printing board having a multilayer structure. In this printing board, a first conductor layer (uppermost layer) on which an electronic component is to be mounted is formed only of lands for mounting of an electronic component, in order to improve mounting accuracy of the electronic component. In addition, the lands have the same shape for maximizing the self-alignment effect during mounting of the electronic component, and a circuit pattern connected to the electronic circuit is electrically connected in second and subsequent conductor layers via the through-holes provided in the lands.

In the present embodiment, the microLED 80 of a four-terminal package illustrated in FIGS. 6A and 6B is exemplified as the electronic component to be surface-mounted. Although the multilayer board 100 may include any number of layers, a multilayer board having four conductor layers is exemplified in accordance with the number of electrodes of the microLED 80. The four conductor layers are referred to, from the top, as a first conductor layer, a second conductor layer, a third conductor layer, and a fourth conductor layer, in sequence. The insulating layers providing interlayer insulation are referred to, from the top, as a first insulating layer, a second insulating layer, a third insulating layer, and a fourth insulating layer, in sequence.

As illustrated in (A) of FIG. 7, the multilayer board 100 includes a mounting area 110 for mounting of the microLED 80, and a connector portion 120 for connection of the multilayer board 100 to a socket or the like. In the mounting area 110, a plurality of the microLEDs 80 arranged in a matrix are soldered to corresponding lands. The outer shape of the package of the microLED 80 is, for example, a rectangular shape in which Lx=0.43 millimeters (mm) and Ly=0.43 mm (width). The length of one side of the R electrode, G electrode, B electrode, or C electrode formed to be substantially rectangular on the bottom surface of the package is about 0.11 mm. A space S between the electrodes is about 0.1 mm.

The first conductor layer, which is the uppermost layer of the multilayer board 100, is provided with a matrix of a plurality of lands 130R, 130G, 130B, and 130C (which will be referred to as lands 130 when collectively referred to) for soldering of the R electrode, G electrode, B electrode, and C electrode of the microLED 80. A set of the lands 130R, 130G, 130B, and 130C for one microLED 80 are formed at positions corresponding to the R electrode, G electrode, B electrode, and C electrode. The lands 130R, 130G, 130B, and 130C have a substantially rectangular shape in a plan view, and have the same shape. A plurality of such sets of the lands 130 are regularly arranged in a matrix at a constant pitch.

Through-holes 140 are positioned directly below approximately center positions of the lands 130. Each of the through-holes 140 is a through-hole formed in the insulating layer, and the interior of the through-hole 140 is filled with a conductive material. The through-hole 140 enables electrical connection between the conductor layers above and below the insulating layer. Therefore, each of the lands 130 formed in the first conductor layer is electrically connected to the interconnect pattern formed in the second conductor layer through the through-hole 140. Also, the through-hole 140 may be formed across a plurality of insulating layers. For example, when the through-hole 140 is formed at the same position of the first insulating layer and the second insulating layer, the land 130 of the first conductor layer can be electrically connected to the interconnect pattern formed on the third conductor layer via the through-hole 140. Alternatively, when the through-hole 140 is formed at the same position of the first insulating layer, the second insulating layer, and the third insulating layer, the land 130 of the first conductor layer can be electrically connected to the interconnect pattern formed on the fourth conductor layer via the through-hole 140.

When only the lands 130 having the same shape are formed in the first conductor layer and the interconnect pattern is formed in the conductor layer below the first conductor layer, thermal behaviors of melting or solidifying of solder when soldering the microLED 80 to the lands 130 are substantially dependent on the lands. The lands having the same shape achieve heat dissipation that is uniform between the lands when the melted solder is solidified, which maximizes the self-alignment effect due to the surface tension of solder. This enables the microLED 80 to be soldered to the lands with high accuracy, and suppresses positional displacement, rotation, inclination, and standing of the microLED 80, thereby reducing occurrence of mounting failures of the microLED 80. When one set of lands are arranged to be bilaterally or rotationally symmetrical, the microLED 80 can be soldered to the lands with higher accuracy.

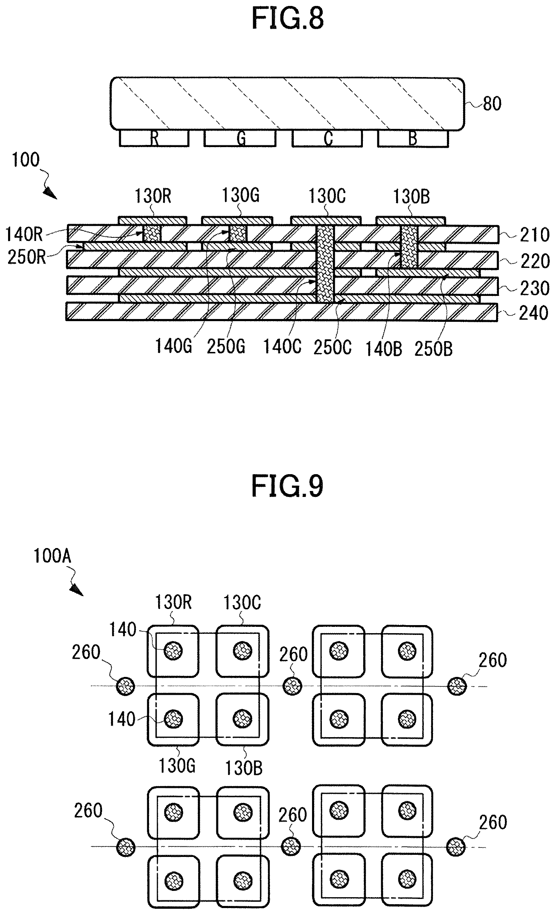

FIG. 8 is a diagram illustrating a cross-sectional structure of the multilayer board. The multilayer board 100 includes a first insulating layer 210, a second insulating layer 220, a third insulating layer 230, and a fourth insulating layer 240. The lands 130R, 130G, 130B, and 130C are processed in the first conductor layer formed on the upper surface of the first insulating layer 210. Here, for ease of understanding of the description, the R electrode, G electrode, B electrode, and C electrode of the microLED 80 are illustrated to be arranged in a row, and similarly, the lands 130R, 130G, 130B, and 130C are illustrated to be arranged in a row.

The land 130R is electrically connected to an interconnect pattern 250R formed in the second conductor layer via a through-hole 140R formed in the first insulating layer 210. The land 130G is electrically connected to an interconnect pattern 250G formed in the second conductor layer via a through-hole 140G formed in the first insulating layer 210. The land 130B is electrically connected to an interconnect pattern 250B formed in the third conductor layer via a through-hole 140B formed in the first insulating layer 210 and the second insulating layer 220. The land 130C is electrically connected to an interconnect pattern 250C formed in the fourth conductor layer via a through-hole 140C formed in the first insulating layer 210, the second insulating layer 220, and the third insulating layer 230. The through-holes 140R, 140G, 140B, and 140C are through-holes that penetrate through the one or more insulating layers. For example, the through-holes are plated with copper to fill the through-holes with a metal material, thereby enabling electrical connection between the upper and lower conductor layers.

The interconnect patterns 250R, 250G, 250B, and 250C of the multilayer board 100 are connected to a drive circuit (not shown) via the connector portion 120.

Since currents from R, G, and B flow into the interconnect pattern 250C connected to the C electrode, heat generation of the interconnect pattern 250C increases. Therefore, by forming the interconnect pattern 250C in the fourth conductor layer and extending the area of the interconnect pattern 250C, heat dissipation is increased such that heat can readily escape to the outside. Although the interconnect patterns 250R and 250G respectively connected to the R electrode and the G electrode are formed in the second conductor layer, this is merely an example. It is acceptable that only the interconnect pattern 250R connected to the R electrode or only the interconnect pattern 250B connected to the B electrode be formed in the second conductor layer. Alternatively, one more conductor layer may be formed in the multilayer board, and the interconnect patterns 250R, 250G, 250B, and 250C may be formed in the respective conductor layers. Also, when there is an extra space in the conductor layer, three interconnect patterns may be formed in the single conductor layer.

Next, a second embodiment of the present disclosure will be described. FIG. 9 is a plan diagram of a multilayer board according to the second embodiment. In the second embodiment, the first conductor layer of a multilayer board 100A includes, in addition to the lands 130, alignment marks 260 for positioning and mounting the microLEDs on the lands. For example, the alignment marks 260 are patterned simultaneously with patterning of the lands 130. The alignment marks 260 are arranged in spaces each defining a pitch between each set of the lands 130. By provision of the alignment marks 260, the microLEDs 80 can be positioned on the lands 130 with higher accuracy, and the self-alignment effect is exhibited more effectively. Therefore, it is possible to reduce mounting failures of the microLEDs in solder reflow. Note that the shape, number, or position of the alignment marks illustrated in FIG. 9 is merely an example, and the shape, number, or position of the alignment marks is not necessarily limited to this.

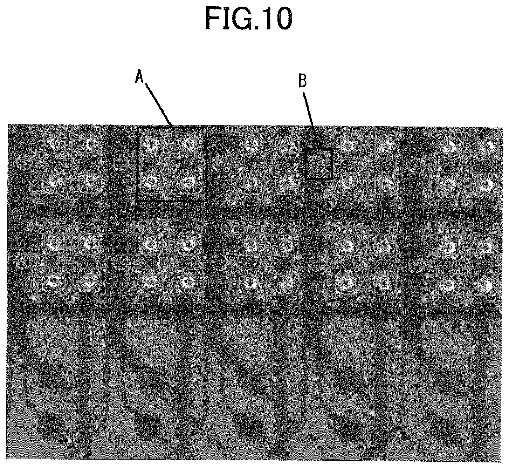

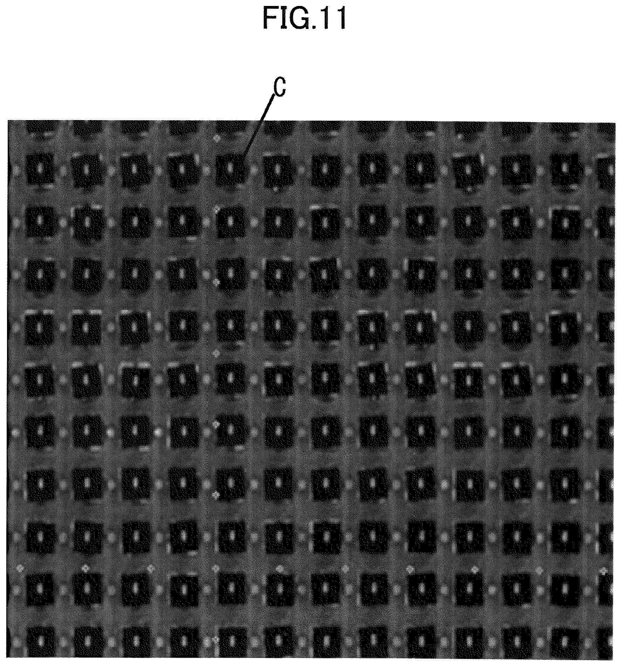

FIG. 10 is a plan diagram illustrating an actual multilayer board according to the second embodiment. In FIG. 10, a region indicated by A indicates the set of lands, and a region indicated by B indicates the alignment mark. FIG. 11 is a diagram illustrating the microLEDs that are surface-mounted on the multilayer board according to the second embodiment. In FIG. 11, a portion indicated by C indicates the microLED. As is clear from FIG. 11, the microLEDs are favorably soldered to the lands without positional displacement, rotation, standing, or the like.

The multilayer board of the present disclosure, and in particular the first and second embodiments of the present disclosure have the following advantageous effects.
1. The self-alignment effect at the time of reflow mounting is maximized, and the electronic component can be reliably mounted at the intended position.
2. Since the lands for mounting of the electronic component have the same shape, the frequency of occurrence of mounting failures of the electronic component, such as positional displacement, rotation, inclination, standing, or the like, is reduced.
3. When the electronic component to be mounted is an LED, the LED can appropriately control any color and emit light of any color.
4. When the electronic component to be mounted is an LED, the LED is mounted to be horizontal relative to the lands, the optical axis is not inclined, and the intended luminance or chromaticity can be achieved.

Although embodiments have been described based on an example in which the microLED of the four-terminal package is surface-mounted, this is merely an example, and the present disclosure is not limited to this. For example, the microLED may be a six-terminal package in which anode electrodes and cathode electrodes of the light emitting elements of R, G, and B are independent. Alternatively, the microLED may be such that individual chips of R, G, and B, not packaged, are mounted. The electronic component to be surface-mounted may be an electronic component other than the microLED.

Although embodiments have been described based on an example in which the land has a rectangular shape, this is merely an example. The planar shape of the land may be any other shape (e.g., a circular shape, an elliptical shape, a rectangular shape having a different aspect ratio, or a polygonal shape). That is, the planar shape of the land can be appropriately changed in accordance with the shape, size, number, and pitch of the electrodes of the electronic component to be mounted. Further, although embodiments have been described based on an example in which the number of the layers of the multilayer board is four, the present disclosure is not limited to this. The number of the layers of the multilayer board can be appropriately selected in accordance with the number of electronic components to be surface-mounted, the number and size of interconnect patterns, and the like. The present disclosure is applicable to a multilayer board including two or more conductor layers.

Although embodiments of the present disclosure have been described above in detail, the present disclosure is not limited to these specific embodiments. Various modifications and alterations are possible within the scope of claims recited.

According to aspects of the present disclosure, since the lands having the same shape are formed in the first conductor layer and the interconnect pattern is formed in the second conductor layer, melting or solidifying of the solder is made uniform between the lands, thereby maximizing the self-alignment effect due to the surface tension of the solder. As a result, the positional displacement, rotation, inclination, and standing of the electronic component are suppressed, and the occurrence of mounting failures of the electronic component is reduced.

## Claims

1. A multilayer board, comprising:
a first conductor layer;
a second conductor layer; and
an insulating layer, wherein
the first conductor layer and the second conductor layer are stacked via the insulating layer,
the first conductor layer includes a plurality of lands to which an electrode of an electronic component for surface mounting is to be soldered,
the second conductor layer includes an interconnect pattern electrically connected to the lands via a conductive through-hole formed in the insulating layer, and
the plurality of lands have a same planar shape.

2. The multilayer board according to claim 1, wherein
the first conductive layer includes an alignment mark for positioning the electronic component on the lands.

3. The multilayer board according to claim 1 or 2, wherein
the electronic component is a package that includes light emitting elements of R, G, and B, and in which at least an R electrode, a G electrode, a B electrode, and a C (common) electrode are formed on a bottom surface of the package.

4. The multilayer board according to claim 3, wherein
a set of the lands to which the R electrode, the G electrode, the B electrode, and the C electrode are to be connected are arranged to be rotationally or linearly symmetrical.

5. The multilayer board according to claim 3 or 4, further comprising:
a third conductor layer and a fourth conductor layer, wherein
the second conductor layer includes the interconnect pattern electrically connected to at least one electrode of the R electrode, the G electrode, or the B electrode,
the third conductor layer includes the interconnect pattern electrically connected to at least one electrode of the R electrode, the G electrode, or the B electrode, and
the fourth conductor layer includes the interconnect pattern electrically connected to the C electrode.
